# EUROPEAN PATENT SPECIFICATION

(11) **EP 1 280 392 B1**
(45) Date of publication and mention of the grant of the patent: **28.11.2007**
(21) Application number: 01830497.2
(22) Date of filing: 26.07.2001
(51) Int. Cl.: H05K 3/46, H05K 1/02, H01L 23/66

(54) **Printed circuit board and relevant manufacturing method for the installation of microwave chips up to 80 Ghz**
Leiterplatte und entsprechendes Herstellungsverfahren zur Installation von Mikrowellenchips bis zu 80 Ghz
Panneau à circuit imprimé et son procédé de fabrication pour l'installation de puces à micro-ondes jusqu'à 80 Ghz

(43) Date of publication of application: 29.01.2003
(73) Proprietor: Siemens S.p.A., 20126 Milano (IT)
(72) Inventor: Biffi, Giovanni Ivano, 20056 Grezzago (MI) (IT); Buoli, Carlo, San Martino Spino, 41030 Mirandola (MO) (IT); Zingirian, Alessandro, 16145 Genova (IT)
(74) Representative: Giustini, Delio

(56) References cited:
- DE-A- 2 656 489
- GB-A- 2 124 035
- GB-A- 2 189 084
- US-A- 4 999 740
- US-A- 5 198 964
- US-B1- 6 178 311
- MUELLER H: "KRITERIEN DER HOCHTECHNOLOGIE-MULTILAYER" GALVANOTECHNIK, EUGEN G.LEUZE VERLAG. SAULGAU/WURTT, DE, vol. 78, no. 10, October 1987 (1987-10), pages 2990-2996, XP002169682 ISSN: 0016-4232
- PATENT ABSTRACTS OF JAPAN vol. 013, no. 120 (P-846), 24 March 1989 (1989-03-24) & JP 63 292079 A (ASIA ELECTRON KK), 29 November 1988 (1988-11-29)

## Description

### Field of the invention

The present invention relates to the field of microwave circuits and more in particular to a printed circuit board with planar circuits up to 80 GHz and relevant manufacturing method.

### Background art

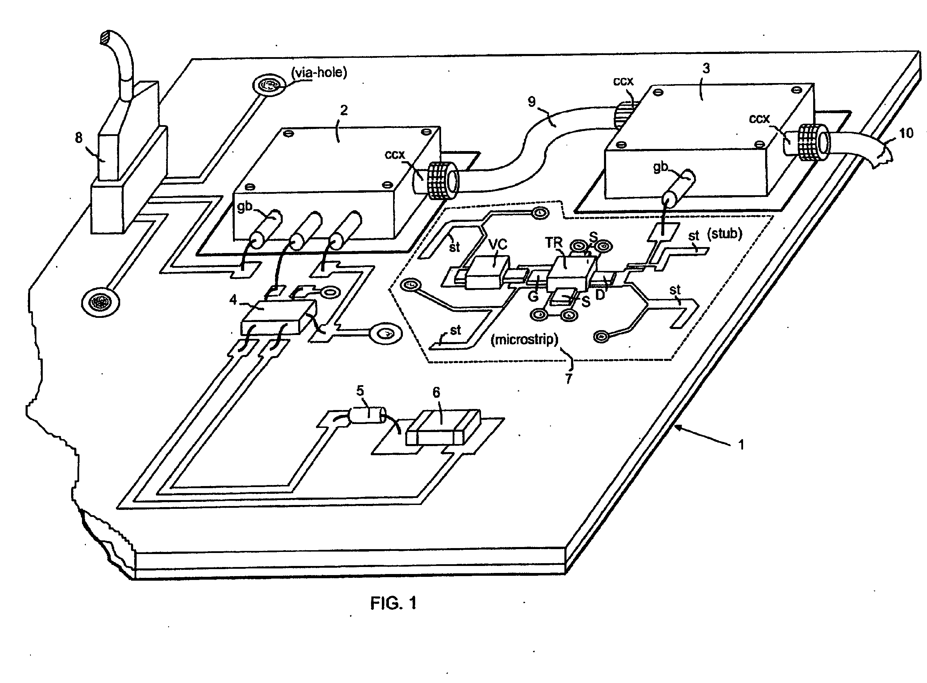

Figure 1 shows, in general, a circuit board including microwave networks, and not, implemented according to the criteria of the most recent known art. It can be noticed a dielectric substrate 1, of the multilayer type, as those in fibre-glass reinforced plastic usually employed in the printed circuit technique. The substrate 1 supports a circuit layout on the front side, including metallized holes for the via-holes (via-hole) towards the other layers. Connected to the above mentioned layout we can see: two microwave circuit modules 2 and 3 implemented according to the known methods, an integrated circuit 4 operating at low frequency, a resistor 5 with a capacitor 6, a voltage controlled oscillator 7, and an input/output connector 8 for the transport of supplies and of low frequency signals. The substrate 1 with the above mentioned circuit forms a functional unit included as a precautionary measure in a metal case (not visible in the figure) furnishing mechanical support and heat dissipation possibility. More units of this type are opportunely interconnected within an equipment, for instance a transceiver, housed in an appropriate frame.

The metal cases 2 and 3 include microstrip circuits (microstrip) on alumina substrate, visible in a subsequent figure. The walls of the metal cases are crossed by cylindrical connectors gb (for instance of the type known as glass-bead), connected to the circuit layout on substrate 1, at one end, and to the layouts on alumina, at the other end, for the transport of supply to active devices within modules 2 and 3, and for the input/output of some signals involving microwave circuits inside the modules. The above mentioned walls are also crossed by one or more coaxial connectors ccx for a same number of coaxial cables 9 and 10, of interconnection between-modules 2 and 3 and input/output modules of microwave signals, respectively, from, and to, other functional units similar to those shown in figure 1.

The geometric shape of the circuit layout insisting on the substrate 1 has only indicative nature of the state of the art, in the actual case a similar layout is anywhere involved by signals having lower frequencies compared to microwaves, with the sole exception of the area indicated with a dotted line, concerning the voltage controlled oscillator 7, or VCO (Voltage Controlled Oscillator), involved by microwave signals.

This possibility to employ substrates characterized by high dielectric losses, such as for instance those in fibre-glass reinforced plastic, to implement microwave VCO is described in EP 992107 in the name of the same Applicant. In this specific case the microwaves could reach 18 GHz without altering the VCO operation characteristics.

In figure1, we can notice that the VCO 7 consists of a transistor TR of the GaAsFET type, in inverted channel configuration, connected to a varactor VC and to a supply and control circuit placed on another area of substrate 1, not shown in the figure, reached through metallized holes. The GaAsFET TR and the varactor VC are devices equipped with hermetic case from which the contact metal elements come out. On the rear side of the first lamination of substrate 1 a metallized area is present coinciding with the VCO 7 for the microstrip formation.

As it can be noticed, the area occupied by the layout of VCO 7 is a minimum one, thus minimizing the power loss of the microwave oscillation during its propagation through the high loss substrate. To this purpose, the source electrode of the GaAsFET TR is directly welded to the grounding plane through metallized holes, the varactor VC is placed in strict contact with the gate electrode of the GaAsFET TR, and the VCO does not include the traditional resonant recess with the included dielectric resonator; four stubs st are also employed in critical interconnection points of the assembly consisting of the transistor-varactor with the remaining of the VCO 7, to prevent the circulation of the microwave signal on supply lines. It was not necessary to include the VCO 7 in a metal case, considering its scarce electromagnetic interference on the adjacent areas of substrate 1.

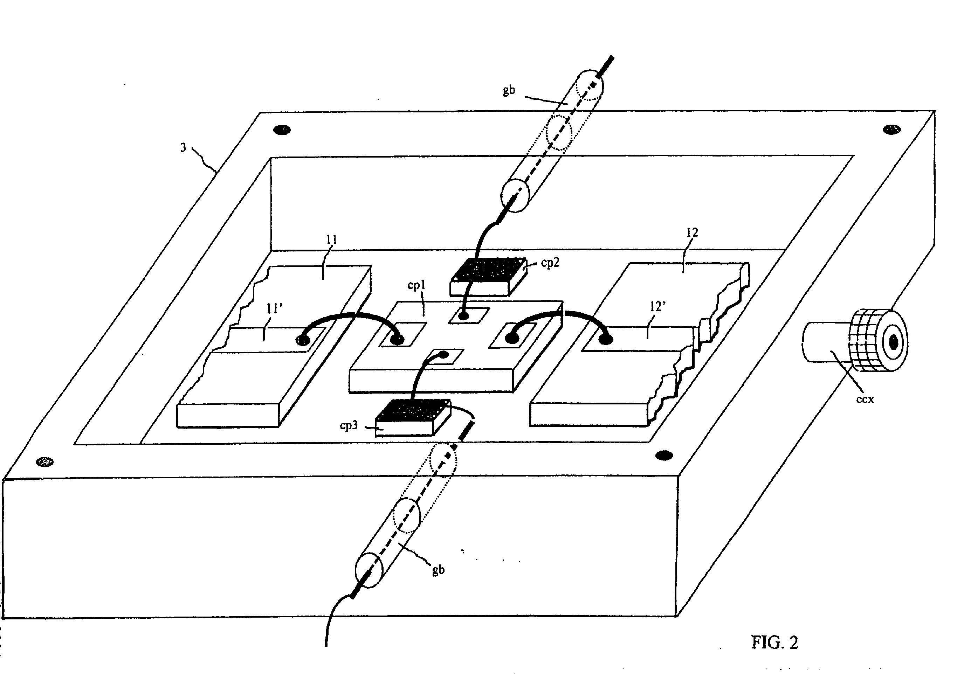

With reference to figure 2, it can be noticed the generic microwave module 3 of figure 1, in which the cover of the metal case has been removed to show three bare chip microwave devices (in-chip) cp1, cp2 and cp3, and two alumina substrates 11 and 12 adequately metallized on both sides, in order to obtain two corresponding layouts in microstrip, shown by lines 11' and 12', respectively. In-chip devices and the alumina substrates are glued to the metal case 3 through a conductive resin, or welded. The chip cp1 is a monolithic microwave integrated circuit, known also with the acronym MMIC (Monolithic Microwave Integrated Circuit), the chips cp2 and cp3 are two monolithic capacitors filtering the supply voltages. As already known, in-chip devices have no case and have terminals in shape of metal pads on the silica substrate, and a grounding contact corresponding to a more extended metalization on the rear side. The capacitors cp2 and cp3 have an electrode connected to the ground directly on the metal case 3 and the other electrode connected to a relevant terminal of the chip cp1; two additional electrodes of chip cp1 are connected to microstrips 11' and 12' for the input and output of the signals. The connections are made through thermal compression welding made by hand. The circuit configuration represented in figure 2 is given only as an indication of the state of the art in the field of microwave integrated circuits (MIC) employing low dielectric loss substrates included in metal cases.

It is now possible to highlight some limits of microwave integrated circuits in the known art. It must be highlighted first that, notwithstanding the advantages deriving from the invention described in the mentioned patent application in the name of the same Applicant, clearly stressed by layout 7 of figure 1, we see that the same figure indicates also the impossibility to extend the implementation setting featuring the VCO 7, to the whole microwave circuit. This impossibility derives from two concurrent causes, out of which a first one is just that of the high losses of the substrate in fibre-glass reinforced plastic, a little bit more than 1 dB for wavelength, and a second one is the impossibility to dissipate thermal power in the fastening area of microwave chips having a particular dissipation capacity. It is emphasized that the mentioned invention concerned only the implementation of a VCO, that is of circuits crossed by scarce electric power, in which the path covered by the microwave signal was reduced to the minimum extent; notwithstanding these measures, the maximum operation frequency did not exceed 18 GHz. This means that in more general utilization conditions of the microwave circuits, compared to those defined for the VCO mentioned above, concerning both the frequency and the power value in transit, it is not possible to avail of the advantages to obtain both the circuits operating at low frequency and the microwave circuits on a single board in fibre-glass reinforced plastic. Since in the technique of telecommunication equipment we assist to a continuous shifting of frequency limits (at present over 50 GHz), considering the need to have to amplify the signals to transmit, and the fact that it is not always possible to minimize the length of microstrips, we can say that the usual realization techniques of microwave circuits leading to the assembly of figure 1 are still dominant, though in presence of the mentioned invention relevant to the VCO 7. From the above, we see how the microwave modules 2 and 3 of figure 1 are profitably dedicated to circuits operating at frequencies higher than 18 GHz, and/or crossed by non negligible electric powers, or still, when the high losses of the substrate would involve the impossibility to obtain layouts that could be physically implemented.

Inside the above mentioned modules, the fastening of bare chips directly to the metal case enables to adequately dissipate the thermal power developed, giving at the same time a best electrical grounding. Moreover, dielectric losses of alumina substrates 11 and 12 of figure 2 are very low, and they can even be neglected also reaching high frequencies. Therefore, the limitations to the microwaves of the multilayer cards in fibre-glass reinforced plastic have no importance for microwave modules 2 and 3 of Figure 1.

Therefore, the hope to extend to microwave circuits the same automatic or semiautomatic assembly techniques, already widely used in the implementation of printed circuit cards would appear thwarted. These negative conclusions would be strengthened by the additional limitation in frequency, not ascribable to the substrate losses, that a microwave layout on the front side would encounter due to the fact that it does not avail of a good grounding contact on this side. In fact, being the grounding plane placed on the multilayer rear side, metallized holes become necessary to implement the above mentioned contacts. The known induction effects of this type of connections limit the band, adding to the limiting effects due to the case of microwave monolithics. The losses of the glass fibre substrate are in any case the dominant factor that makes any layout at frequencies significantly higher than 18 GHz impossible to be implemented. The drawback is tied to the physical nature of the electromagnetic propagation phenomena in the materials, and therefore it is intrinsically impossible to eliminate. To make up the attenuation introduced by the substrate, it would be necessary to distribute the amplification along a path in microstrip, but at the present state of the technique it appears not reasonable to follow up this way. It is then binding the utilization of low dielectric loss substrates and, to avoid interference, the use of relevant electromagnetic radiation shielding cases, that is, the continued application of the known configuration of figure 1.

The other aspect binding to the known configuration of figure 1, was the unfitness of heat dissipation through the substrates in fibre-glass reinforced plastic. In the technique of printed circuits a power dissipation device is installed on a heat dissipator having adequate shape and dimensions, to the purpose of avoiding the relevant overheating. The application of these elementary thermodynamic considerations to a microwave device, involves as well the installation of the same on a heat dissipator, which in the known technique coincides with the internal wall of the metal case including also alumines. Therefore, it is difficult to try overcoming the teachings of the known art in the field.

The configuration of figure 1, with the integration of figure 2, shows a functional unit including microwave networks in which the technology more particularly dedicated to the electrical portion, that is, the one relevant to the deposit of conductive layouts and surface installation of components, has to be inexorably considered with the mechanical one of metal cases and connectors. The "hybrid" appearance of the product thus obtained prevents reaching a complete automation of the assembly procedure of microwave circuits.

### Object of the invention

Therefore, scope of the present invention is to overcome the drawbacks of the known art towards a complete automation of the assembly procedure of microwave circuits, and to indicate a printed circuit board supporting a planar microwave circuit.

### Summary of the invention

To attain these objects, scope of the present invention is a printed circuit board including a high dielectric loss substrate supporting microwave planar circuits, co-operating with a planar circuit operating at a lower frequency and with bias networks to reach a pre-determined functionality, **characterized in that** it also includes:
- Slots in pre-determined areas of said high dielectric loss substrate, for the insertion of the components of said microwave planar circuits;
- a metal sheet, preferably copper made, adherent to said dielectric substrate and having thickness such to offer mechanical support means and of adequate heat dissipation to said microwave components inserted in said dielectric substrate; said metal sheet forming also an electrical grounding plane for the above mentioned components and for additional connection points of said printed circuit, enabling also the conductive lines of said planar circuit to operate as microstrips, as described in claim 1.

### Advantages of the invention

Profitably, the printed circuit board according to the invention, though including microwave circuits, can be assembled with the usual surface installation techniques.

Also advantageously, the microwave planar circuits do not suffer of those limitations in use and in power frequency that can be dissipated, which on the contrary affected the operation of the previous microwave circuits on high dielectric loss substrate, such as for instance the VCO of figure 1. In fact, the idea to open slots in the high dielectric loss substrate for the insertion of microwave components to be placed in contact with a thick copper sheet underneath, enabled to cope with the mechanical support, heat dissipation, and electrical grounding functions provided by metal cases of microwave modules according to the known art.

The same idea enabled also to employ alumina strips with relevant circuit layouts in microstrip as microwave components.

All the above enabled to bypass, where necessary, the strong attenuation suffered by the signals along the microstrips on high loss substrates and to eliminate the metal cases, at least when the microwave circuits does not significantly irradiate within the substrate. On the contrary, when the interfering electromagnetic irradiation is significant, the case shielding function is made up by an embodiment in which a crown of metallized holes is obtained in said dielectric substrate all around a microwave circuit section whose electromagnetic irradiation would otherwise interfere with the operation of the remaining circuits.

Therefore, another object of the invention is an embodiment referred to said shielding crowns of metallized holes, as it results from claim 2.

Profitably, the crown of metallized holes can perfectly shield an irradiating circuit section, since the interfering radiation generated by a microstrip mainly propagates within the dielectric substrate, finding a barrier in metallized holes when the distance between adjacent holes is sufficiently lower than the wavelength of the microwave signal.

Therefore, the invention enables to obtain also the residual shielding function, otherwise still to be assigned to the metal cases, availing of the same technique of printed circuits being already employed for the realization of the printed circuit board. According to the above, the causes that prevented in the known art the implementation of a microwave circuit board according to the automatic (or semiautomatic) techniques of the surface installation appear completely removed.

Profitably, additional layers of high dielectric loss material can be integrated in the previous lamination enabling a better exploitation of the surface, component side, that is, to reach a higher circuit density per surface unit, an easier connection to input/output connectors of the signal and of supplies, and an additional stiffening of the structure.

A further scope of the invention is a procedure for the implementation of the printed circuit board including the microwave planar circuits previously described, as it results from the appended claims 11 and 12.

### Brief description of figures

The present invention, together with further objects and advantages may be understood from the following detailed description of an embodiment of the same taken in conjunction with the attached drawings, in which:
- Figure 1 shows a prospect view of a microwave circuit card according to the known art;
- Figure 2 shows the content of a microwave module marked with 3 in figure 1;
- Figure 3 shows a substrate of the multilayer type used in the present invention;
- Figure 4 shows a microwave bare chip installed on the substrate of figure 3;
- Figure 5 shows a microwave circulator installed on the substrate of figure 3;
- Figure 6 shows a metallized hole connecting a track on met1 with one on met3 through the multilayer of figure 3;
- Figure 7 shows a longitudinal section view of a transition from a microstrip of the substrate of figure 3 to a mechanical wave guide;
- Figure 8 shows an exploded view of the multilayer of figure 3 highlighting a circuit part surrounded by a crown of metallized holes crossing the multilayer; and
- Figure 9 shows a prospect view of a hypothetical microwave circuit card illustrating the present invention.

### Detailed description of some preferred embodiments of the invention

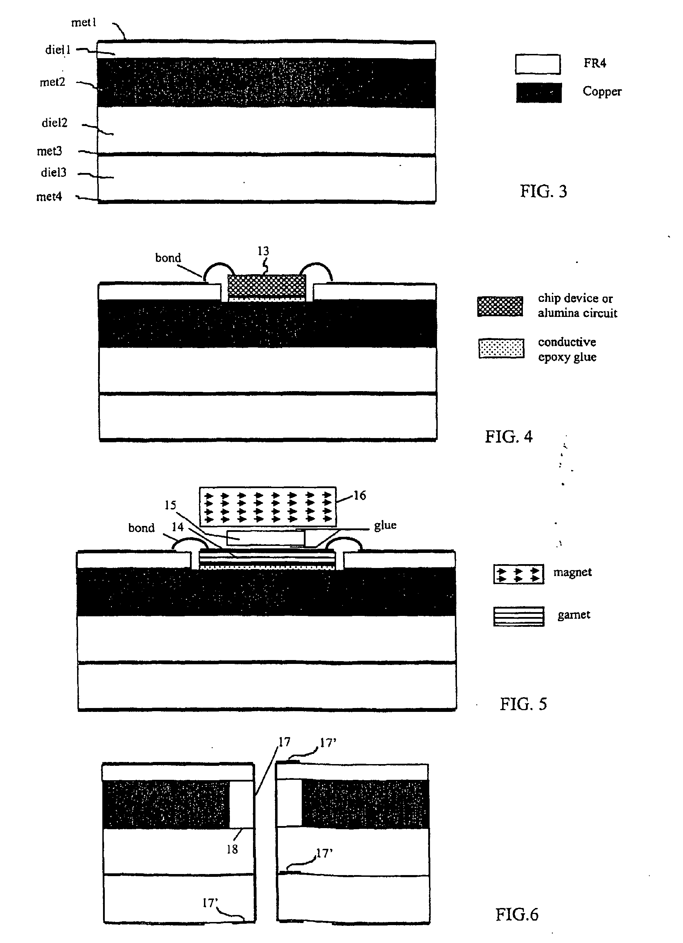

With reference to figure 3 it can be noticed a structure consisting of the following superimposed layers, listed starting from top to bottom: met1, diel1, met2, diel2, met3, diel3, and met4. The layers met1, met2, met3, and met4 are metal layers, preferably copper made, while the remaining layers correspond to a same number of vetronite boards, that is a material made of glass fibres impregnated with epoxy resin. The vetronite is characterized by a tan δ value from 0,025 to 0,05, which configures it as suitable to the application in the printed circuits sector, but not in that of microwave circuits, where alumina imposes with a tan δ = 0,0001. More in detail, the dielectric layer diel1 has 100 µm thickness, while the layers diel2 and diel3 have each a thickness of 300 µm. The layer met1 is referred to a layout placed on the front side of the dielectric board diel1, the layout includes some microstrips. The layer met2 consists of a copper sheet having opportune thickness, for instance 1mm. The layer met3 is referred to an intermediate layout placed on one face of the board diel3, on the other face of which the layer met4 corresponds to a grounding plane. With the details supplied, the board diel2 has the sole function to isolate the layout met3, placed on the adjacent board diel3, from the copper sheet met2. An equivalent implementation is that in which the layout met3 is placed on the surface of the board diel2 not in contact with the copper sheet met2. The techniques to obtain a multilayer starting from single metalized dielectric boards are known in printed circuits.

In compliance with the scope of the present invention, which aims at extending to microwave circuits (as general as possible) the realization techniques of the printed circuit cards, it is important to meet also the same realization standards of printed circuits such as for instance, metal lines having width W not lower than 200 µm. The implementation of a microstrip on the layer met1 requires that its dimensioning, intended as width W of the conductive line and thickness h of the interposed layer diel1, enables the propagation of a quasi-TEM mode in the dielectric strip included between the copper sheet met2 and the line standing above. This occurs when the wavelength λ of the propagating microwave signal is far higher than the microstrip width. A ratio of approximately 10 between λ and W is to be considered as reasonable. Starting from a width W of 200 µm for the microstrips, we have only to find the thickness h enabling to reach the characteristic impedance of 50 Ω. The above mentioned thickness h resulted to be 100 µm, just as that indicated for the dielectric layer diel1 With a width W of 200 µm the ratie (λ/W) = 10 involves a signal frequency of approximately 78 GHz. At equal characteristic impedance, higher widths W involve also higher thickness h and lower frequencies of the signal propagating along the microstrip. Concerning the attenuation suffered by the signal, it is a little bit higher than 1 dB over a distance of one wavelength. In some applications, this attenuation does not represent a great problem if we have care to minimize the extension of the involved networks; in the contrary instance a portion of the layout can be made in microstrip, instead of vetronite, directly on alumina strips. These are used as microwave chips as indicated in the next figure.

With reference to figure 4, it can be noticed a microwave component 13 installed on the multilayer indicated in the previous figure 3. To this purpose, the first dielectric layer diel1 shows an appropriate opening for the introduction of the component 13, which is fastened to the copper sheet met2 underlying by means of conductive resin. The subject component can be a device, or a circuit, a bare chip monolithic (MMIC), or as an alternative a network on alumina; in both the cases, a grounding plane is foreseen on the lower surface of the component 13. It can be appreciated how this type of fastening enables the realisation of a best connection to ground of the component 13, directly made on the copper sheet met2, which in turn shall be connected to the mechanical part along one free edge of the underlying lamination. It is thus avoided the connection to ground of the microwave components through metalized holes, that occurred on the contrary in the VCO of the closest known art, eliminating the induction effects of a so-called hot mass that limits the maximum operation frequency. The connection of the supplies to the chip 13 and the input/output of the relevant signal, are made through thin gold wires welded by thermal compression between microstrip and chip contacts, this operation being called "bonding". To maintain the chip input and output impedance at 50 Ω it is necessary that the relevant connections are extremely short; this is possible if the thickness of the first dielectric layer diel1 can be compared to that of the bare chip, or of aluminas, as it results in fact for the thickness of 100 µm adopted for the layer diel1. In the practice, it is convenient to cover the chips and the connection gold wires with an adequate protection resin of the marketable type.
Figure 5 refers to the case in which the component inserted in the opening of the first dielectric layer of figure 4 is a microwave circulator, this consists of a circular garnet 14 supporting a layout in microstrip, towered over by a permanent magnet 16. It is also foreseen a spacer 15, glued between the garnet 14 and the magnet 16, to protect the gold wires for the connection with the circulator.

Figure 6 shows a metallized hole 17 crossing the multilayer of figure 3 to implement a connection between the conductive lines of the surface layout met1 and the tracks of the intermediate layout met3. This last layout is profitably referred to the supply tracks of the active components front side, or to other low frequency networks, but it can also include striplines capable of conveying signals up to some gigahertz. As it can be noticed, the metalization of hole 17 melts with that of opportune circular crowns 17' surrounding the hole edge on the three dielectric substrates. To avoid a ground short circuit, the copper sheet met2 has a hole 18 having diameter higher than that of hole 17, as well as the metalization of the grounding plane met4 on the rear side shows circular areas without metalization that include the hole 17 and the circular crown 17'. Of course, the holes 18 shall always be made before the stacking of the copper sheet met2 within the multilayer, in order that the same cab be filled with the resinous material (prepreg) used to glue the layers each other, this material showing electrical characteristics very similar to the fibre-glass reinforced plastic. On multilayer completion, the through drilling and the metalization of holes are made, followed by the surface installation of components, bonding, and the additional finishing operations.

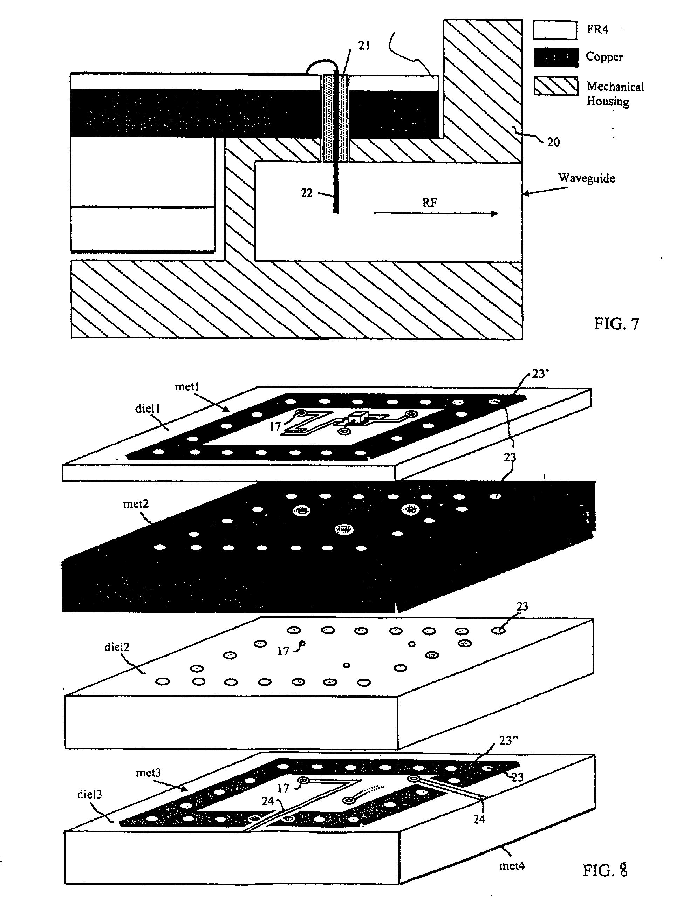

Figure 7 indicates the execution methods of a transition between a microstrip of the layout met1 of figure 3 and a metal wave-guide 20 having rectangular section. To this purpose, the material under the copper sheet met2 is removed from the border adjacent to the guide. In the area laid bare, the thick copper sheet is matched with a wall in the terminal area of the guide and then screwed to a mechanical part incorporating the guide. In a hole crossing in order: the first dielectric layer diel1, the copper layer met2, and the guide wall 20, a transition is inserted consisting of a Teflon cylindrical body 21 crossed along the longitudinal axis by a metal pin 22; the latter protrudes in the upper part for the connection with a microstrip, and comes out in the recess of the guide 22 as an antenna. The indicated microstrip/guide transition is notoriously reciprocal (guide/microstrip).

Figure 8 is referred to the possibility to implement an effective shielding of a microwave circuit section insisting on the first dielectric layer diel1, avoiding the use of appropriate metal cases closed with cover. In a multilayer including microstrips, the irradiation is confined almost only in the multilayer and does not significantly involve the space in air all around. The irradiation mainly takes place through the first dielectric layer diel1, but at a lower extent it involves also the other dielectric layers diel2 and diel3 due to some via-holes with the layer met3, through the metalized holes 17. In the figure, we can see a crown of metallized holes 23, evenly spaced, which crosses the multilayer of figure 3 and encloses the microwave circuit section irradiating electromagnetic power through the multilayer. On the layer diel1 there is a metalization 23' connecting all the holes 23 delimiting the microwave section as a bordering crown. The distance between contiguous holes is approximately one eighth of the wavelength if the microwave signal affects the above-mentioned section, thus the shielding effect is guaranteed. In the underlying copper sheet met2 we can see of course the crown of holes 23 together with holes having higher diameter, of the same type of hole 18 of figure 6. In the two underlying dielectric layers diel2 and diel3 the same hole configuration that crossed the first dielectric layer diel1 can be seen. The metal layout met3 visible on the front face of the third dielectric layer diel3 includes a border crown 23" that differs from the 23' for the sole presence of some openings reserved to the exit of some tracks 24 directed towards other sections of the layout met3. The metalized crown 23" is not strictly necessary and can also be avoided.

The high dielectric losses of substrates diel1, diel2, and diel3 help additionally reducing the electromagnetic interference and the consequent risk of self-oscillations, playing a role similar to that of the sheets in electromagnetic radiation absorbing material (eccosorb) that are usually glued to the internal face of the cover of metal cases of microwave modules.

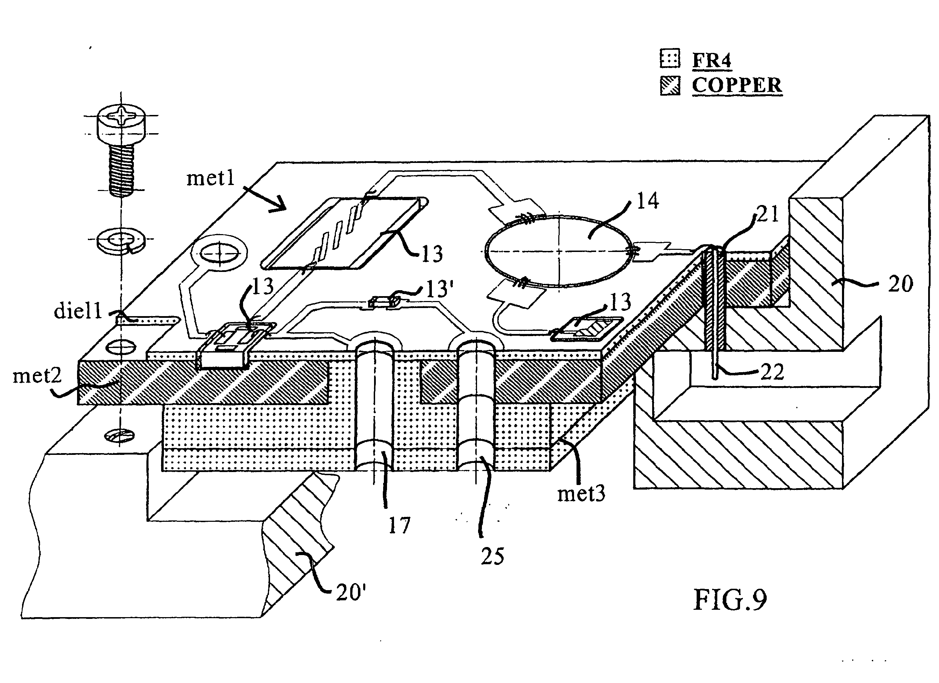

Figure 9 is a prospect view of a hypothetical microwave multilayer circuit board according to the invention, as it appears after assembly. The view effectively summarizes what already anticipated in the description of the previous figures 3 to 7 where, for simplicity sake, the shielding crown of the holes in figure 8 is not shown. The distance, the size of components, and the thickness of the different substrates (for drawing reasons) do not have the right real proportions. From the figure it can be appreciated how the multilayer circuit board is stoutly installed with the edge of the copper sheet met2 in contact with the wave-guide 20 and of a mechanical part 20', to which the plate is firmly fixed with screws. The layout met1 is visible on the front side together with the different typology of microwave components 13 and 14, as they appear inserted in the relevant slots of the first dielectric substrate diel1 and in contact with the thick copper sheet met2. For completeness, it is also considered the case, however rather frequent, of a component 13' resting on the dielectric diel1 where it is welded to the microstrip. The transition 20, 21 is visible from metal wave-guide microstrip. It can be noticed the section of a metalized hole 17 for the connection with the intermediate layout, and that of a second metalized hole 25 for the connection with the grounding plane on the rear side. In the case of the second hole, contrarily to the first one, the area without metalization around the edge of the hole is made only on the third metal layer met3.

The advantages that the invention of such a circuit shows compared to a corresponding circuit according to the known art represented in figure 1 can be understood from figure 9. The above mentioned advantages are represented by the fact that the circuits appear now as an homogeneous product, that is, made of a simple printed circuit card, without mechanical micromodules dedicated to the microwave networks, and therefore without connectors, bonds, and coaxial cables for interfacing of micromodules. All the above translates in a lower circuit overall dimension and in a saving in the additional costs of the mechanical part and connectors.

As far as the realization procedure is concerned, it avails of some steps similar to those usually employed in the sector of printed circuits for the execution of a complete multilayer of a surface layout, and of one or more intermediate layouts interconnected to the layout on the component side through via-hole, as well as of connections with a grounding plane on the rear side through metalized holes. These steps, individually known are interposed by other steps that are peculiar to the implementation of the subject invention, and therefore featuring it. That is:
- a step to obtain a copper sheet met2 of appropriate thickness drilled in pre-determined points not to short circuit the connection at least at an intermediate layout;
- a hole filling step with setting resinous material of the same type of that used for the dielectric substrates:

- an insertion step of the sheet met2, as previously worked, between the first dielectric layer diel1 and the multilayer consisting of the dielectric layers diel2 and diel3, to perform the functions already described in detail;
- a drilling step of the multilayer along a border line enclosing a microwave circuit section that irradiates through the dielectric;
- a metalization step of the holes obtained in the previous step;
- a grinding step for the opening of windows in the first dielectric layer diel1 for the insertion of bare chip components microwave operating, or of circulators, or still, of microwave networks on alumina or on other substrates (for instance, PTFE) that show intermediate losses between alumina and vetronite. In any case, the components inserted are all featured by a metalization on the rear side;
- a step for the removal of a lamination strip along one edge of the copper sheet met2, for the fixing to the mechanical part and the grounding of the same;
- a fixing step of the above mentioned microwave components to the copper sheet met2;
- a bonding step of the above mentioned microwave components, made by hand or in semiautomatic manner;
- a possible covering step of components in chip and of relevant bonds with a protection resin;
- and finally a fixing step of the multilayer to the mechanical part.

On the contrary, concerning the known steps, they are the following:
- masking step of the front side of the first and third dielectric layer, diel1 and diel3, respectively;
- copper removal steps from the substrates diel1 and diel3 to obtain layouts corresponding to layers met1 and met3;
- a stacking step of dielectric substrates diel2 and diel3;
- a drilling step of the whole multilayer, for the implementation of via-hole connections between the layout front side and the intermediate layout, and with the backplane;
- and finally a surface installation step of the discrete components and of monolithic components fit with case, made in automated mode.

From the cognition detected up to now, those skilled in the art can order the known steps and the featuring ones in the more adequate way within a logic sequence leading from the single substrates to the finished product. As it can be noticed, the steps characterizing the invention are dominant compared to the known ones.

Concerning the drawing up of an appended claim of the procedure, it seems to be not opportune to recognize in the preamble the existence of the VCO described in the patent application mentioned above in the name of the same Applicant, since the lamination therein described does not differ from that commonly employed in printed circuit cards.

In the case of non particularly complex circuits, with microstrips not significantly irradiating within the dielectric substrate, the invention can be implemented without the need to have recourse to a multilayer for the support of intermediate layouts, and without the need to have recourse to the shielding crown of metalized holes. In this case, the sole construction supports employed are the first dielectric layer diel1 and the thick copper sheet met2, and of course the mechanical part. The sole necessary metalization is that of the surface layout met1, with the possible addition of metallized holes for the connection to the grounding plane consisting of copper met2. In the case considered, the procedure according to the invention avails of the following steps:
- a step to obtain a copper sheet met2 of appropriate thickness;
- a binding step of the first dielectric layer diel1 to the copper sheet met2, to perform the functions widely described;
- a grinding step (or chemical attack) for the opening of slots within the first dielectric layer diel1 for the insertion of bare chip components microwave operating, or as an alternative, of networks on alumina, or of circulators;
- a fixing step of the above mentioned microwave components to the copper sheet met2;
- a bonding step of the above mentioned components;
- a possible covering step of in chip components and of the relevant bonds with a protection resin;
- and finally a fixing step of the multilayer to the mechanical part.

In conclusion, the advantages that the invention of the subject procedure introduces in the manufacturing of a professional telecommunication equipment appear now evident, such as for instance a radio link. These advantages translate into the possibility to apply to microwave circuits, without any design restriction, the surface installation methods already widely used in the implementation of printed circuit cards operating at well lower frequencies. As a result, it is obtained a significant reduction of mounting times and production costs compared to the traditional procedures, which foresee the implementation of microwave modules, individually interfaced to the intermediate frequency circuits and to the supply circuits and alarms.

Summing up the advantages of the product and procedure of the invention, we can assume that the subject invention opens a new era in the field of microwave equipment, and not only in the telecommunication domain, an era herald of further progresses towards the circuit integration and the miniaturisation at the ever increasing utilization frequencies.

## Claims

1. Printed circuit board including a high dielectric loss substrate, supporting microwave planar circuits, co-operating with a planar circuit operating at a lower frequency and with bias networks to reach a pre-determined functionality, **characterized in that** it also includes:
- slots in pre-determined areas of said high dielectric loss substrate (diel1), for the insertion of microwave components (13, 14) of said microwave planar circuits equipped with grounding metalization on the rear side;
- a metal sheet (met2), preferably copper made, adherent to said dielectric substrate (diel1), and having a thickness such as to offer mechanical support means and adequate heat dissipation to said microwave components (13, 14) inserted in said dielectric substrate (diel1); said metal sheet (met2) forming also an electrical grounding plane for the above mentioned components and for other connection points of said printed circuit board, enabling also the conductive lines (met1) of said planar circuit to operate as microstrips;
- at least a second and a third high dielectric loss layer (diel2, diel3) with conductive lines placed in between, forming an intermediate layout (met3) placed on a surface of one of said additional layers (diel2, diel3), to form with the first high dielectric loss substrate (diel1) and with said metal sheet (met2) a multilayer structure.

2. Printed circuit board according to claim 1, **characterized in that** it includes bordering crowns of metallized holes (23, 23') including relevant sections of said microwave circuits that irradiate power through said high dielectric loss substrate (diel1), the distance between contiguous holes being such as to prevent the irradiated power to cross said crowns (23, 23') and to propagate through said substrate (diel1).

3. Printed circuit board according to claim 1 or 2, **characterized in that** it also includes:
- a grounding plane both on the metal sheet (met2) and on the rear side (met4) and said crowns of metallized holes (23) crossing the multilayer
- second metallized holes (17, 17') for the connection of the intermediate layout (met3) to conductive lines, component side (met1) of said planar circuits;
- third metallized holes (25) for the connection of pre-determined points of said conductive lines (met1, met3) with said grounding plane (met4) on the rear side.

4. Printed circuit board according to one of the previous claims, **characterized in that** the thickness of said high dielectric loss substrate (diel1) can be compared to that of said microwave components (13), thus minimizing the length of the connections to said microstrips.

5. Printed circuit board according to claim 4, **characterized in that** the thickness of said high dielectric loss substrate (diel1) is such to enable to obtain microstrips with the desired characteristic impedance and with minimum width in compliance with the standards foreseen for printed circuit cards.

6. Printed circuit board according to one of the previous claims, **characterized in that** said microwave components introduced in said slots opened in the high dielectric loss substrate (diel1) are bare chips (13) glued to said metal sheet (met2) with conductive resin, or welded.

7. Printed circuit board according to any claim 1 to 5, **characterized in that** said microwave components introduced in said slots opened in the high dielectric loss substrate (diel1) are single circuits in microstrip (13) on low dielectric loss substrate, preferably in the form of alumina strips, glued to said metal sheet (met2) by means of conductive resin, or welded.

8. Printed circuit board according to any claim 1 to 5, **characterized in that** said microwave components introduced in said slots opened in the high dielectric loss substrate (diel1) are circulators (14).

9. Printed circuit board according to one of the previous claims, **characterized in that** said metal sheet (met2) has at least an area along one edge resulting free from lamination for the connection to a support mechanical component (20') acting also as electrical grounding; said mechanical portion can coincide with the metal wall of a rectangular wave guide (20), coupled to said microstrip components side through a transition (21, 22) crossing said metal sheet (met2) and said metal wall.

10. Printed circuit board according to one of the previous claims, **characterized in that**, said microwaves extend up to approximately 80 GHz.

11. Manufacturing method of a printed circuit board including deposition steps of conductive lines of a planar circuit on a high dielectric loss substrate, and surface installation steps of the components of this circuit, **characterized in that** it also includes:
a) a step to obtain a metal sheet (met2), preferably copper made, having thickness suitable to confer mechanical strength to said printed circuit board and possibility of effective heat dissipation;
b) a glueing step of said high dielectric loss substrate (diel1) to said metal sheet (met2);
c) a grinding step of areas of the first dielectric substrate (diel1) up to laying bare said metal sheet underneath, matching installation slots for microwave components (13, 14) fitted with grounding metalization on the rear side;
d) an insertion step of the above mentioned microwave components (13, 14) in said slots and of relevant fastening to said metal sheet (met2), forming also an electric grounding for the above mentioned components and for additional connection points of said printed circuit board, enabling also said conductive lines (met1) to operate as microstrips; and
e) a connection step of the above mentioned microwave components (13, 14) to said microstrips.

12. Manufacturing method of a printed circuit board including deposition steps of conductive lines of a planar circuit on high dielectric loss substrates for the formation of a multilayer circuit with a grounding plane (met4) metallized on the rear side, and a surface installation step of the components of said circuits, **characterized in that** it also includes the following steps:
a) drilling of a metal sheet (met2), preferably copper made, in points provided for the via-holes towards at least an intermediate layout (met3), the thickness of the sheet being suitable to give mechanical strength to said printed circuit board and possibility of effective heat dissipation;
b) glueing of a first of said high dielectric loss substrates (diel1) to said metal sheet (met2);
c) filling of the holes of said metal sheet (met2) with a setting resinous material of the same nature of the material employed in the manufacturing of said dielectric substrates (diel1, diel2, diel3);
d) completion of said multilayer - drilling of the multilayer in points matching the connections towards said at least one intermediate layout and towards said grounding plane on the rear side - metalization of said holes;
e) grinding of areas of the first dielectric substrate (diel1) up to lying bare said metal sheet (met2) underneath, matching the installation slots of microwave components (13, 14) fitted with grounding metalization on the rear side;
f) insertion of the above mentioned microwave components (13, 14) in said slots opened in the first dielectric layer (diel1) and relevant fixing to said metal sheet (met2), forming also an electrical grounding for the above mentioned components and enabling also said conductive lines (met1) to operate as microstrips; and
g) a connection step of the above-mentioned microwave components (13, 14) to said microstrips.

13. Manufacturing method of a printed circuit board according to claim 11 or 12, **characterized in that** it includes an additional drilling step of the multilayer (diel1, met2; diel1, met2, diel2, diel3, met4) and of hole metalization (23) to obtain bordering crowns (23, 23'; 23, 23'. 23") including relevant microwave circuit sections irradiating power through a high dielectric loss substrate (diel1; diel1 diel2, diel3), the distance between contiguous holes being such to prevent the radiated power to cross said crowns and to propagate through said substrate.

14. Manufacturing method of a printed circuit board according to any claim 11 to 13, **characterized in that** said fixing step of microwave components (13, 14) to said metal sheet (met2) is made through gluing with conductive resin.

15. Manufacturing method of a printed circuit board according to any claim 11 to 13, **characterized in that** said fixing step of microwave components (13, 14) to said metal sheet (met2) is made through welding.

16. Manufacturing method of a printed circuit board according to any claim 11 to 15, **characterized in that** it also includes a covering step of said microwave components (13, 14) and relevant bonds with a protective glue.

17. Manufacturing method of a printed circuit board according to any claim 12 to 16, **characterized in that** it additionally includes a lying bare step along at least one edge of said metal sheet (met2), to fix said printed circuit board to a support mechanical structure (20, 20') and the connection to ground of the same.

## Patentansprüche

1. Leiterplatte, die ein Substrat mit hohem dielektrischem Verlust aufweist, das planare Mikrowellenschaltungen trägt, die mit einer bei einer niedrigeren Frequenz arbeitenden planaren Schaltung und mit Bias-Netzwerken zusammenwirken, um eine vorgegebene Funktionalität zu erreichen, **dadurch gekennzeichnet, dass** sie außerdem aufweist:
- Schlitze in vorgegebenen Bereichen des besagten Substrats mit hohem dielektrischem Verlust (diel1), zum Einsetzen von Mikrowellenkomponenten (13, 14) der besagten planaren Mikrowellenschaltungen, die mit einer Erdungs-Metallisierung auf der Rückseite ausgestattet sind;
- ein vorzugsweise aus Kupfer hergestelltes Blech (met2), das an dem besagten dielektrischen Substrat (diel1) anhaftet und eine solche Dicke aufweist, dass es ein mechanisches Abstützungsmittel und eine ausreichende Wärmeableitung für die besagten Mikrowellenkomponenten (13, 14) bietet, die in das besagte dielektrische Substrat (diel1) eingesetzt sind; wobei das besagte Blech (met2) außerdem eine elektrische Erdungsebene für die oben erwähnten Komponenten und für andere Anschlusspunkte der besagten Leiterplatte bildet, die außerdem ermöglicht, dass die Leiterbahnen (met1) der besagten planaren Schaltung als Mikrostreifen fungieren;
- wenigstens eine zweite und eine dritte Schicht mit hohem dielektrischem Verlust (diel2, diel3) mit zwischen ihnen angebrachten Leiterbahnen, die ein Zwischenlayout (met3) bilden, das auf einer Fläche einer der besagten zusätzlichen Schichten (die12, die13) angebracht ist, um mit dem ersten Substrat mit hohem dielektrischem Verlust (diel1) und mit dem besagten Blech (met2) eine Mehrschichtstruktur zu bilden.

2. Leiterplatte nach Anspruch 1, **dadurch gekennzeichnet, dass** sie begrenzende Kränze von metallisierten Löchern (23, 23') aufweist, die relevante Abschnitte der besagten Mikrowellenschaltungen einschließen, welche Leistung durch das besagte Substrat mit hohem dielektrischem Verlust (diel1) hindurch abstrahlen, wobei der Abstand zwischen benachbarten Löchern so beschaffen ist, dass verhindert wird, dass die abgestrahlte Leistung die besagten Kränze (23, 23') durchquert und sich durch das besagte Substrat (diel1) hindurch ausbreitet.

3. Leiterplatte nach Anspruch 1 oder 2, **dadurch gekennzeichnet, dass** sie außerdem aufweist:
- eine Erdungsebene sowohl auf dem Blech (met2) als auch auf der Rückseite (met4) und den besagten Kränzen von metallisierten Löchern (23), welche die Mehrschichtstruktur durchqueren;
- zweite metallisierte Löcher (17, 17') zur Verbindung des Zwischenlayouts (met3) mit Leiterbahnen auf der Bauelementeseite (met1) der besagten planaren Schaltungen;
- dritte metallisierte Löcher (25) zur Verbindung von vorbestimmten Punkten der besagten Leiterbahnen (met1, met3) mit der besagten Erdungsebene (met4) auf der Rückseite.

4. Leiterplatte nach einem der vorhergehenden Ansprüche, **dadurch gekennzeichnet, dass** die Dicke des besagten Substrats mit hohem dielektrischem Verlust (diel1) mit der der besagten Mikrowellenkomponenten (13) verglichen werden kann, wodurch die Länge der Verbindungen zu den besagten Mikrostreifen auf ein Minimum begrenzt wird.

5. Leiterplatte nach Anspruch 4, **dadurch gekennzeichnet, dass** die Dicke des besagten Substrats mit hohem dielektrischem Verlust (diel1) eine solche ist, dass sie ermöglicht, Mikrostreifen mit der gewünschten charakteristischen Impedanz und mit minimaler Breite in Übereinstimmung mit den für Leiterkarten vorgesehenen Standards zu erhalten.

6. Leiterplatte nach einem der vorhergehenden Ansprüche, **dadurch gekennzeichnet, dass** die besagten Mikrowellenkomponenten, die in die besagten, in dem Substrat mit hohem dielektrischem Verlust (diel1) vorhandenen Schlitze eingeführt werden, Nacktchips (13) sind, die an das besagte Blech (met2) mit leitfähigem Harz geklebt oder angeschweißt sind.

7. Leiterplatte nach einem der Ansprüche 1 bis 5, **dadurch gekennzeichnet, dass** die besagten Mikrowellenkomponenten, die in die besagten, in dem Substrat mit hohem dielektrischem Verlust (diel1) vorhandenen Schlitze eingeführt werden, einzelne Mikrostreifenschaltungen (13) auf einem Substrat mit niedrigem dielektrischem Verlust sind, vorzugsweise in der Form von Aluminiumoxidstreifen, die an das besagte Blech (met2) mit leitfähigem Harz geklebt oder angeschweißt sind.

8. Leiterplatte nach einem der Ansprüche 1 bis 5, **dadurch gekennzeichnet, dass** die besagten Mikrowellenkomponenten, die in die besagten, in dem Substrat mit hohem dielektrischem Verlust (diel1) vorhandenen Schlitze eingeführt werden, Zirkulatoren (14) sind.

9. Leiterplatte nach einem der vorhergehenden Ansprüche, **dadurch gekennzeichnet, dass** das besagte Blech (met2) wenigstens einen Bereich entlang eines Randes aufweist, der sich als frei von laminarer Beschichtung erweist, für die Verbindung mit einer mechanischen Stützkomponente (20'), die auch als eine elektrische Erdung wirkt; wobei der besagte mechanische Abschnitt mit der Metallwand eines rechteckigen Wellenleiters (20) zusammenfallen kann, der mit der besagten Mikrostreifen-Komponentenseite durch einen Übergang (21, 22) verbunden ist, der das besagte Blech (met2) und die besagte Metallwand durchquert.

10. Leiterplatte nach einem der vorhergehenden Ansprüche, **dadurch gekennzeichnet, dass** die besagten Mikrowellen sich nach oben bis ungefähr 80 GHz erstrecken.

11. Herstellungsverfahren für eine Leiterplatte, welches Schritte der Aufbringung von Leiterbahnen einer planaren Schaltung auf ein Substrat mit hohem dielektrischem Verlust und Schritte der Oberflächeninstallation der Komponenten dieser Schaltung umfasst, **dadurch gekennzeichnet, dass** es außerdem umfasst:
a) einen Schritt, um ein vorzugsweise aus Kupfer hergestelltes Blech (met2) zu erhalten, das eine Dicke aufweist, die geeignet ist, der besagten Leiterplatte mechanische Festigkeit zu verleihen und die Möglichkeit einer wirksamen Wärmeableitung zu verschaffen;
b) einen Schritt des Klebens des besagten Substrats mit hohem dielektrischem Verlust (diel1) an das besagte Blech (met2);
c) einen Schritt des Schleifens von Bereichen des ersten dielektrischen Substrats (diel1) bis zum Freilegen des darunter befindlichen Bleches, die mit Installationsschlitzen für Mikrowellenkomponenten (13, 14) übereinstimmen, die mit einer Erdungs-Metallisierung auf der Rückseite ausgestattet sind;
d) einen Schritt des Einsetzens der oben erwähnten Mikrowellenkomponenten (13, 14) in die besagten Schlitze und des entsprechenden Befestigens an dem besagten Blech (met2), das außerdem eine elektrische Erdung für die oben erwähnten Komponenten und für zusätzliche Anschlusspunkte der besagten Leiterplatte bildet und außerdem ermöglicht, dass die besagten Leiterbahnen (met1) als Mikrostreifen fungieren; und
e) einen Schritt des Verbindens der oben erwähnten Mikrowellenkomponenten (13, 14) mit den besagten Mikrostreifen.

12. Herstellungsverfahren für eine Leiterplatte, welches Schritte der Aufbringung von Leiterbahnen einer planaren Schaltung auf Substrate mit hohem dielektrischem Verlust für die Bildung einer Mehrschichtschaltung mit einer auf der Rückseite metallisierten Erdungsebene (met4) und einen Schritt der Oberflächeninstallation der Komponenten der besagten Schaltungen umfasst, **dadurch gekennzeichnet, dass** es außerdem die folgenden Schritte umfasst:
a) Bohren eines vorzugsweise aus Kupfer hergestellten Bleches (met2) an für die Verbindungslöcher vorgesehenen Stellen zu wenigstens einem Zwischenlayout (met3), wobei die Dicke des Bleches geeignet ist, der besagten Leiterplatte mechanische Festigkeit zu verleihen und die Möglichkeit einer wirksamen Wärmeableitung zu verschaffen;
b) Kleben eines ersten von den besagten Substraten mit hohem dielektrischem Verlust (diel1) an das besagte Blech (met2);
c) Füllen der Löcher des besagten Bleches (met2) mit einem abbindenden Harzmaterial von derselben Art wie das Material, das bei der Herstellung der besagten dielektrischen Substrate (diel1, diel2, diel3) verwendet wird;
d) Fertigstellung der besagten Mehrschichtstruktur - Bohren der Mehrschichtstruktur an Stellen, die mit den Verbindungen zu dem besagten wenigstens einen Zwischenlayout und zu der besagten Erdungsebene auf der Rückseite übereinstimmen - Metallisierung der besagten Löcher;
e) Schleifen von Bereichen des ersten dielektrischen Substrats (diel1) bis zum Freilegen des besagten darunter befindlichen Bleches (met2), die mit den Installationsschlitzen für Mikrowellenkomponenten (13, 14) übereinstimmen, die mit einer Erdungs-Metallisierung auf der Rückseite ausgestattet sind;
f) Einsetzen der oben erwähnten Mikrowellenkomponenten (13, 14) in die besagten, in der ersten dielektrischen Schicht (diel1) vorhandenen Schlitze und entsprechendes Befestigen an dem besagten Blech (met2), das außerdem eine elektrische Erdung für die oben erwähnten Komponenten bildet und außerdem ermöglicht, dass die besagten Leiterbahnen (met1) als Mikrostreifen fungieren; und
g) einen Schritt des Verbindens der oben erwähnten Mikrowellenkomponenten (13, 14) mit den besagten Mikrostreifen.

13. Herstellungsverfahren für eine Leiterplatte nach Anspruch 11 oder 12, **dadurch gekennzeichnet, dass** es einen zusätzlichen Schritt des Bohrens der Mehrschichtstruktur (diel1, met2; diel1, met2, diel2, diel3, met4) und der Metallisierung der Löcher (23) umfasst, um begrenzende Kränze (23, 23'; 23, 23'. 23") zu erhalten, die relevante Abschnitte der Mikrowellenschaltungen einschließen, welche Leistung durch ein Substrat mit hohem dielektrischem Verlust (diel1; diel1, diel2, diel3) hindurch abstrahlen, wobei der Abstand zwischen benachbarten Löchern so beschaffen ist, dass verhindert wird, dass die abgestrahlte Leistung die besagten Kränze durchquert und sich durch das besagte Substrat hindurch ausbreitet.

14. Herstellungsverfahren für eine Leiterplatte nach einem der Ansprüche 11 bis 13, **dadurch gekennzeichnet, dass** der besagte Schritt des Befestigens der Mikrowellenkomponenten (13, 14) an dem besagten Blech (met2) durch Kleben mit leitfähigem Harz ausgeführt wird.

15. Herstellungsverfahren für eine Leiterplatte nach einem der Ansprüche 11 bis 13, **dadurch gekennzeichnet, dass** der besagte Schritt des Befestigens der Mikrowellenkomponenten (13, 14) an dem besagten Blech (met2) durch Schweißen ausgeführt wird.

16. Herstellungsverfahren für eine Leiterplatte nach einem der Ansprüche 11 bis 15, **dadurch gekennzeichnet, dass** es außerdem einen Schritt des Bedeckens der besagten Mikrowellenkomponenten (13, 14) und zugehörigen Bondverbindungen mit einem Schutzkleber umfasst.

17. Herstellungsverfahren für eine Leiterplatte nach einem der Ansprüche 12 bis 16, **dadurch gekennzeichnet, dass** es zusätzlich einen Schritt des Freilegens des besagten Bleches (met2) entlang wenigstens eines Randes umfasst, um die besagte Leiterplatte an einer mechanischen Stützkonstruktion (20, 20') und der Verbindung derselben zu Erde zu befestigen.

## Revendications

1. Carte de circuit imprimé incluant un substrat à perte diélectrique élevée, supportant des circuits planaires à micro-ondes, coopérant avec un circuit planaire fonctionnant à une fréquence plus basse et avec des réseaux de polarisation pour atteindre une fonctionnalité prédéterminée, **caractérisée en ce qu'**elle inclut également :
- des fentes dans des zones prédéterminées dudit substrat à perte diélectrique élevée (diel1), pour l'insertion de composants à micro-ondes (13, 14) desdits circuits planaires à micro-ondes équipés d'une métallisation de mise à la masse sur le côté arrière ;
- une feuille de métal (met2), préférablement constituée de cuivre, adhérant audit substrat diélectrique (diel1), et ayant une épaisseur de manière à apporter un moyen de support mécanique et une dissipation adéquate de la chaleur auxdits composants à micro-ondes (13, 14) insérés dans ledit substrat diélectrique (diel1) ; ladite feuille de métal (met2) formant également un plan de masse électrique pour les composants mentionnés ci-dessus et pour d'autres points de connexion de ladite carte de circuit imprimé, permettant également que les lignes conductrices (met1) dudit circuit planaire fonctionnent comme des microrubans ;
- au moins une deuxième et une troisième couches à perte diélectrique élevée (diel2, diel3) avec des lignes conductrices placées entre celles-ci, formant une topologie intermédiaire (met3) placée sur une surface de l'une desdites couches additionnelles (diel2, diel3), pour former avec le premier substrat à perte diélectrique élevée (diel1) et avec ladite feuille de métal (met2) une structure multicouche.

2. Carte de circuit imprimé selon la revendication 1, **caractérisée en ce qu'**elle inclut des couronnes bordurantes de trous métallisés (23, 23') incluant des sections pertinentes desdits circuits à micro-ondes qui rayonnent l'énergie à travers ledit substrat à perte diélectrique élevée (diel1), la distance entre trous contigus étant telle qu'elle empêche que l'énergie rayonnée ne traverse lesdites couronnes (23, 23') et ne se propage à travers ledit substrat (diel1).

3. Carte de circuit imprimé selon la revendication 1 ou 2, **caractérisée en ce qu'**elle inclut également :
- un plan de masse à la fois sur la feuille de métal (met2) et sur le côté arrière (met4) et lesdites couronnes de trous métallisés (23) traversant la multicouche
- des deuxièmes trous métallisés (17, 17') pour la connexion de la topologie intermédiaire (met3) à des lignes conductrices, du côté composant (met1) desdits circuits planaires ;
- des troisièmes trous métallisés (25) pour la connexion de points prédéterminés desdites lignes conductrices (met1, met3) avec ledit plan de masse (met4) sur le côté arrière.

4. Carte de circuit imprimé selon l'une des revendications précédentes, **caractérisée en ce que** l'épaisseur dudit substrat à perte diélectrique élevée (diel1) peut être comparée à celle desdits composants à micro-ondes (13), minimisant ainsi la longueur des connexions auxdits microrubans.

5. Carte de circuit imprimé selon la revendication 4, **caractérisée en ce que** l'épaisseur dudit substrat à perte diélectrique élevée (diel1) est telle qu'elle permet d'obtenir des microrubans avec l'impédance caractéristique désirée et avec une largeur minimum en conformité avec les normes prévues pour les cartes de circuit imprimé.

6. Carte de circuit imprimé selon l'une des revendications précédentes, **caractérisée en ce que** lesdits composants à micro-ondes introduits dans lesdites fentes ouvertes dans le substrat à perte diélectrique élevée (diel1) sont des puces nues (13) collées sur ladite feuille de métal (met2) avec une résine conductrice, ou soudées.

7. Carte de circuit imprimé selon l'une quelconque des revendications 1 à 5, **caractérisée en ce que** lesdits composants à micro-ondes introduits dans lesdites fentes ouvertes dans le substrat à perte diélectrique élevée (diel1) sont des circuits uniques dans un microruban (13) sur un substrat à perte diélectrique faible, préférablement sous la forme de rubans d'alumine, collés sur ladite feuille de métal (met2) avec une résine conductrice, ou soudés.

8. Carte de circuit imprimé selon l'une quelconque des revendications 1 à 5, **caractérisée en ce que** lesdits composants à micro-ondes introduits dans lesdites fentes ouvertes dans le substrat à perte diélectrique élevée (diel1) sont des circulateurs (14).

9. Carte de circuit imprimé selon l'une des revendications précédentes, **caractérisée en ce que** ladite feuille de métal (met2) a au moins une zone le long d'un bord résultant exempte de laminage pour la connexion à un composant mécanique de support (20') agissant également comme une masse électrique ; ladite portion mécanique peut coïncider avec la paroi de métal d'un guide d'onde rectangulaire (20), couplé audit côté des composants en microruban par l'intermédiaire d'une transition (21, 22) croisant ladite feuille de métal (met2) et ladite paroi de métal.

10. Carte de circuit imprimé selon l'une des revendications précédentes, **caractérisée en ce que** lesdites micro-ondes s'étendent jusqu'à approximativement 80 GHz.

11. Procédé de fabrication d'une carte de circuit imprimé incluant des étapes de dépôt de lignes conductrices d'un circuit planaire sur un substrat à perte diélectrique élevée, et des étapes d'installation en surface des composants de ce circuit, **caractérisé en ce qu'**il inclut également :
a) une étape pour obtenir une feuille de métal (met2), préférablement constituée de cuivre, ayant une épaisseur appropriée pour conférer une résistance mécanique à ladite carte de circuit imprimé et une possibilité de dissipation efficace de la chaleur ;
b) une étape de collage dudit substrat à perte diélectrique élevée (diel1) sur ladite feuille de métal (met2) ;
c) une étape d'abrasion de zones du premier substrat diélectrique (diel1) jusqu'à mettre à nu ladite feuille de métal sous-jacente, de manière correspondante à des fentes d'installation pour des composants à micro-ondes (13, 14) dotés d'une métallisation de masse sur le côté arrière ;
d) une étape d'insertion des composants à micro-ondes (13, 14) mentionnés ci-dessus dans lesdites fentes et de fixation pertinente sur ladite feuille de métal (met2), en formant également une masse électrique pour les composants mentionnés ci-dessus et pour des points de connexion additionnels de ladite carte de circuit imprimé, permettant également que lesdites lignes conductrices (met1) fonctionnent comme des microrubans ; et
e) une étape de connexion des composants à micro-ondes (13, 14) mentionnés ci-dessus auxdits microrubans.

12. Procédé de fabrication d'une carte de circuit imprimé incluant des étapes de dépôt de lignes conductrices d'un circuit planaire sur des substrats à perte diélectrique élevée pour la formation d'un circuit multicouche avec un plan de masse (met4) métallisé sur le côté arrière, et une étape d'installation en surface des composants desdits circuits, **caractérisé en qu'**il inclut également les étapes suivantes :
a) perçage d'une feuille de métal (met2), préférablement constituée de cuivre, en des points prévus pour les trous traversants vers au moins une topologie intermédiaire (met3), l'épaisseur de la feuille étant appropriée pour donner une résistance mécanique à ladite carte de circuit imprimé et une possibilité de dissipation efficace de la chaleur ;
b) collage d'un premier desdits substrats à perte diélectrique élevée (diel1) sur ladite feuille de métal (met2) ;
c) remplissage des trous de ladite feuille de métal (met2) avec un matériau résineux de prise de la même nature que le matériau employé dans la fabrication desdits substrats diélectriques (diel1, diel2, diel3) ;
d) réalisation de ladite multicouche - perçage de la multicouche en des points correspondant aux connexions vers ladite au moins une topologie intermédiaire et vers ledit plan de masse sur le côté arrière - métallisation desdits trous ;
e) abrasion de zones du premier substrat diélectrique (diel1) jusqu'à mettre à nu ladite feuille de métal (met2) sous-jacente, de manière correspondante aux fentes d'installation de composants à micro-ondes (13, 14) dotés d'une métallisation de masse sur le côté arrière ;
f) insertion des composants à micro-ondes (13, 14) mentionnés ci-dessus dans lesdites fentes ouvertes dans la première couche diélectrique (diel1) et de fixation pertinente sur ladite feuille de métal (met2), en formant également une masse électrique pour les composants mentionnés ci-dessus et permettant également que lesdites lignes conductrices (met1) fonctionnent comme des microrubans ; et
g) une étape de connexion des composants à micro-ondes (13, 14) mentionnés ci-dessus auxdits microrubans.

13. Procédé de fabrication d'une carte de circuit imprimé selon la revendication 11 ou 12, **caractérisé en ce qu'**il inclut une étape de perçage additionnelle de la multicouche (diel1, met2 ; diel1, met2, diel2, diel3, met4) et de métallisation des trous (23) pour obtenir des couronnes bordurantes (23, 23' ; 23, 23', 23") incluant des sections pertinentes de circuits à micro-ondes rayonnant l'énergie à travers un substrat à perte diélectrique élevée (diel1 ; diel1, diel2, diel3), la distance entre trous contigus étant telle qu'elle empêche que l'énergie rayonnée ne traverse lesdites couronnes et ne se propage à travers ledit substrat.

14. Procédé de fabrication d'une carte de circuit imprimé selon l'une quelconque des revendications 11 à 13, **caractérisé en ce que** ladite étape de fixation des composants à micro-ondes (13, 14) sur ladite feuille de métal (met2) est effectuée par collage avec une résine conductrice.

15. Procédé de fabrication d'une carte de circuit imprimé selon l'une quelconque des revendications 11 à 13, **caractérisé en ce que** ladite étape de fixation des composants à micro-ondes (13, 14) sur ladite feuille de métal (met2) est effectuée par soudage.

16. Procédé de fabrication d'une carte de circuit imprimé selon l'une quelconque des revendications 11 à 15, **caractérisé en ce qu'**il inclut également une étape de recouvrement desdits composants à micro-ondes (13, 14) et des liaisons pertinentes avec une colle de protection.

17. Procédé de fabrication d'une carte de circuit imprimé selon l'une quelconque des revendications 12 à 16, **caractérisé en ce qu'**il inclut en outre une étape de mise à nu le long d'au moins un bord de ladite feuille de métal (met2), pour fixer ladite carte de circuit imprimé sur une structure mécanique de support (20, 20') et la connexion à la masse de celle-ci.
